# EUROPEAN PATENT APPLICATION

(11) **EP 2 602 813 A1**
(43) Date of publication of application: **12.06.2013**
(21) Application number: 11814649.7
(22) Date of filing: 02.08.2011
(51) Int. Cl.: H01L 21/205, C23C 16/509, H01L 21/3065, H05H 1/46

(54) **PLASMA TREATMENT DEVICE**

(30) Priority: 02.08.2010 JP 2010173507
(71) Applicant: Osaka University, Suita-shi Osaka 565-0871 (JP); EMD Corporation, Shiga 520-2323 (JP)
(72) Inventor: SETSUHARA, Yuichi, Suita-shi Osaka 565-0871 (JP); EBE, Akinori, Yasu-shi, Shiga 5202323 (JP)
(74) Representative: Hehl, Ulrich
(86) International application number: PCT/JP2011/067698
(87) International publication number: WO 2012/018024

(57) **Abstract**

The problem addressed by the present invention is to provide a plasma processing device capable of easily controlling the energy distribution of electrons in a cloud of plasma according to the kind of gas molecules or their dissociation energy. A plasma processing device 10 according to the present invention includes a plasma processing chamber 1l, a plasma producing chamber 12 communicating with the plasma processing chamber 11, a radio-frequency antenna 16 for producing plasma, a plasma control plate 17 for controlling the energy of electrons in the plasma, as well as an operation rod 171 and a moving mechanism 172 for regulating the position of the plasma control plate 17. In this plasma processing device 10, the energy distribution of the electrons of the plasma produced in the plasma producing chamber 12 can be controlled by regulating the distance between the radio-frequency antenna 16 and the plasma control plate 17 by simply moving the operation rod 171 in its longitudinal direction by the moving mechanism 172. Therefore, a plasma process suitable for the kind of gas molecules to be dissociated and/or their dissociation energy can be easily performed.

## Description

### TECHNICAL FIELD

The present invention relates to a plasma processing device for performing a predetermined process, such as a deposition (film formation) or etching, on a substrate to be processed.

### BACKGROUND ART

Plasma processing devices have been commonly used for the deposition of a thin film on a substrate, for the etching of a substrate and for other purposes. There are various types of plasma processing devices, such as a capacitively coupled type or inductively coupled type. Among those types, the inductively coupled plasma processing device is characterized by its capability of producing high-density plasma to perform a process at high speeds (for example, see Patent Document 1).

A normal process of forming a silicon thin film by a plasma processing device is as follows: Initially, hydrogen gas (H₂) and silane gas (SiH₄) are introduced into a vacuum container, and an electric discharge power is supplied to produce plasma inside the vacuum container. In this process, electrons collide with the molecules of hydrogen gas and silane gas, breaking those molecules into pieces. The thereby created atomic hydrogen radicals and silane-group radicals (SiH₃, SiH₂, SiH and Si) are diffused in the vacuum container and reach the surface of the substrate, forming a silicon thin film on the substrate.

### BACKGROUND ART DOCUMENT

### PATENT DOCUMENT

Patent Document 1: JP-A 2006-286536 (Paragraph [0003])

### SUMMARY OF THE INVENTION

### PROBLEM TO BE SOLVED BY THE INVENTION

In the case of forming a silicon thin film in the previously described manner, it is important to create silicon-group radials and atomic hydrogen radicals with high densities. In particular, in the case of forming a microcrystalline silicon thin film, it is essential to create atomic hydrogen radicals with higher densities than in the case of an amorphous silicon thin film.

The amount of energy necessary for electrons to dissociate hydrogen molecules by electron collision is higher than in the case of dissociating SiH₄ molecules. Accordingly, if the amount of high energy electrons for dissociating hydrogen molecules is increased, or if the plasma density is increased, a significant amount of silane-group molecules will be dissociated simultaneously with the generation of high-density atomic hydrogen radicals, producing a large amount of SiH₂, SiH and Si radicals, which have high sticking coefficients and therefore easily stick to the microcrystalline silicon thin film being formed. The production of such radicals having high sticking coefficients leads to the formation of defects in the film or a decrease in the film density. It also causes the problem that high-order silane radicals (SiₓH_{y} (x>2)) are created in the gas phase, which causes more defects to be formed in the film.

Therefore, in order to form a high-quality microcrystalline silicon thin film with a higher film density and fewer film defects (dangling bonds), it is important to suppress an excessive decomposition of silane-group molecules so as to increase the density of the SiH₃ radical whose sticking coefficient is lower than those of the SiH₂, SiH and Si radicals (approximately one tenth).

However, with conventional plasma processing devices, it is difficult to generate high-density atomic hydrogen radicals while suppressing an excessive decomposition of the silane-group molecules.

The problem to be solved by the present invention is to provide a plasma processing device capable of easily controlling the energy distribution of electrons in a cloud of plasma according to the kind of gas molecules or their dissociation energy.

### MEANS FOR SOLVING THE PROBLEMS

The present invention aimed at solving the previously described problem is a plasma processing device having: a plasma producing chamber; a radio-frequency antenna provided in the plasma producing chamber; a plasma-producing gas introduction unit for introducing a plasma-producing gas into the plasma producing chamber; a plasma processing chamber communicating with the plasma producing chamber; and a processing-gas introduction unit for introducing a processing gas into the plasma processing chamber, and the plasma processing device further including:
a plasma control plate provided in the plasma producing chamber in such a manner that the distance thereof from the radio-frequency antenna is variable; and
a moving system for moving the plasma control plate.

It is preferable to use a differential pressure generator for generating a differential pressure between the plasma producing chamber and the plasma processing chamber. By making the pressure in the plasma producing chamber higher than the pressure in the plasma processing chamber by means of the differential pressure generator, it is possible to prevent the processing gas in the plasma processing chamber from entering the plasma producing chamber and undergoing excessive dissociation. As one example of the differential pressure generator, a plate with a number of perforations may be provided at the boundary between the plasma producing chamber and the plasma processing chamber. As another example, a number of processing-gas introduction tubes serving as the processing-gas introduction unit, each of which has a hole on the side facing the plasma processing chamber, may be arranged, with intervals, at the boundary between the plasma producing chamber and the plasma processing chamber.

In one preferable mode of the plasma processing device according to the present invention, a plurality of the plasma producing chambers are provided so as to process a large-area substrate. The plurality of plasma producing chambers may preferably be arranged at regular intervals on one wall surface of the plasma processing chamber, and an evacuation system for discharging gas from the plasma processing chamber and an evacuation rate regulator for regulating the evacuation rate are provided between the plasma producing chambers. The evacuation system and the evacuation rate regulator are controlled so that the processing gas introduced in the plasma processing chamber will always be retained in the plasma processing chamber for almost the same length of time. By this system, the plasma produced in the plasma producing chambers is prevented from causing an excessive dissociation of the processing gas within the plasma processing chamber.

### EFFECT OF THE INVENTION

The plasma processing device according to the present invention is characterized in that the energy distribution of the electrons in the plasma can be controlled by regulating the distance between the plasma control plate provided in the plasma producing chamber and the radio-frequency antenna installed in the same chamber. When the plasma control plate is moved closer to the radio-frequency antenna, a portion of the electrons in the plasma produced in the plasma producing chamber disappear due to their collision with the plasma control plate, so that the electron density decreases. This decrease in the electron density leads to a corresponding decrease in the mutual collision of the electrons in the plasma, allowing a large number of high-energy electrons to eventually remain in the plasma. As a result, the proportion of electrons in a high-energy region increases within the energy distribution of the electrons. Thus, the energy distribution of the electrons can be easily controlled by simply regulating the distance between the plasma control plate and the radio-frequency antenna. By using this system, the degree of dissociation of the gas molecules can be controlled according to the kind of the gas molecules.

### BRIEF DESCRIPTION OF THE DRAWINGS

Figs. 1A and 1B are vertical and cross sectional schematic views showing an experiment system for investigating a change in the plasma characteristics with respect to the distance between a radio-frequency antenna and a plasma control plate.
Fig. 2A is a graph showing a change in the electron temperature with respect to the distance between the radio-frequency antenna and the plasma control plate, and Fig. 2B is a graph showing a change in the electron density.
Fig. 3A is a graph showing a change in the energy distribution of the electrons with respect to the distance between the radio-frequency antenna and the plasma control plate, and Fig. 3B is a graph showing a change in its relative ratio.
Fig. 4 is a vertical sectional schematic view showing the first embodiment of the plasma processing device according to the present invention.
Figs. 5A and 5B are bottom views each of which shows a separation plate provided at the boundary between the plasma producing chamber and the plasma processing chamber.
Fig. 6 is a vertical sectional schematic view showing the second embodiment of the plasma processing device according to the present invention.
Fig. 7 is a vertical sectional schematic view showing the third embodiment of the plasma processing device according to the present invention.
Fig. 8 is a vertical sectional schematic view showing the first variation of the plasma processing device according to the third embodiment.
Fig. 9A is a vertical sectional schematic view showing the second variation of the plasma processing device according to the third embodiment, and Fig. 9B is a bottom view of the separation plate used in the same device.

### BEST MODE FOR CARRYING OUT THE INVENTION

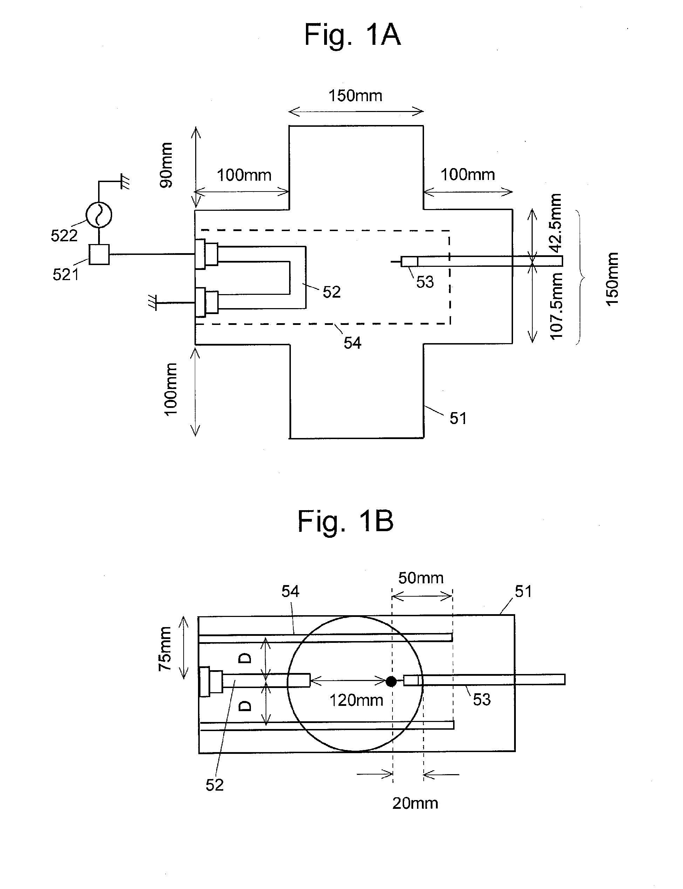

The present inventors have conducted an experiment for investigating a change in the plasma characteristics with respect to the distance between a radio-frequency antenna and a plasma control plate, using an experiment system schematically shown in Fig. 1.
This experiment system includes: a cross-tube chamber 51 made of stainless steel, consisting of two cylindrical tubes of 150 mm in diameter arranged in a mutually crossed form, with one tube extending in the vertical direction and the other tube in the horizontal direction; a radio-frequency antenna 52 consisting of a U-shaped conductor inserted into the cross-tube chamber 51 from one end of the horizontally extending cylindrical tube of the cross-tube chamber 51; a Langmuir probe 53, inserted into the cross-tube chamber 51 from the other end, for measuring various states of the plasma; and a pair of plasma control plates 54 each of which consists of a flat aluminum plate measuring 280 mm in length, 97 mm in width and 6 mm in thickness, the two plates being located at equal distances from both sides of the radio-frequency antenna 52.

The radio-frequency antenna 52 has its two ends of the U-shaped body vertically arranged within in the chamber 51. To one end of this radio-frequency antenna 52, a 13.56-MHz radio-frequency power source 522 with a maximum output of 1,250 watts is connected via an impedance matching box 521, while the other end is grounded. Inside the chamber 51, the radio-frequency antenna 52 is covered with a dielectric pipe to prevent the antenna conductor from undergoing sputtering by the plasma. The portion of the radio-frequency antenna 52 included in the chamber 51 measures 55 mm in the vertical direction and 110 mm in the horizontal direction.

Each of the plasma control plates 54 is connected, via an operation rod extending in the direction perpendicular to the plate surface, to a moving mechanism (not shown). This operation rod can be moved in its longitudinal direction by the moving mechanism, whereby the distance between the plasma control plate 54 and the radio-frequency antenna 52 can be freely regulated.

Though not shown, a port for introducing a plasma-producing gas into the chamber 51 is provided in the upper portion of the vertically extending cylindrical tube. Furthermore, an evacuation port for evacuating the chamber 51 is provided in the lower portion of the same tube.

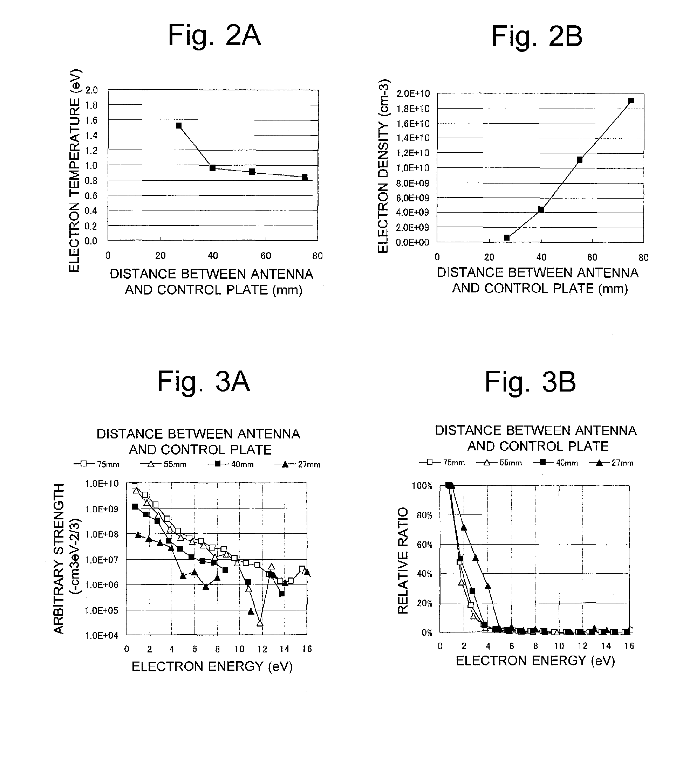

Using the experiment system having the previously described structure, a change in the plasma characteristics with respect to distance D between the radio-frequency antenna 52 and the plasma control plates 54 was investigated. The results of the experiment are as shown in Figs. 2A-3B. The experimental conditions were as follows: As the plasma-producing gas, hydrogen gas was introduced at a flow rate of 5 seem; the output power of the radio-frequency power source was 800 W, the pressure in the chamber 51 was 10 Pa. The measurement of the plasma was performed with the tip of the Langmuir probe 53 positioned at a distance of 120 mm from the radio-frequency antenna 52. It should be noted that the data of D=75 mm shown in the figures are the results of an experiment in which the plasma control plates 54 were removed from the experiment system.

Figs. 2A and 2B demonstrate that, as the distance D decreases, the electron temperature increases while the electron density decreases. Furthermore, the experimental data of Figs. 3A and 3B demonstrate that decreasing the distance D increases the ratio of the electrons in the high-energy region. The reason for this can be inferred from the data of Figs. 2A and 2B as follows: A portion of the electrons in the plasma disappear due to their collisions with the plasma control plates 54, which decreases the electron density and lowers the probability of mutual collisions of the electrons in the plasma, so that abundant electrons with higher energies can remain.

From these experimental results, the present inventors have discovered that the energy distribution of the electrons in the plasma can be effectively controlled by providing a plasma control plate and regulating its distance from the radio-frequency antenna. Hereinafter, embodiments of the plasma processing device according to the present invention will be described.

### FIRST EMBODIMENT

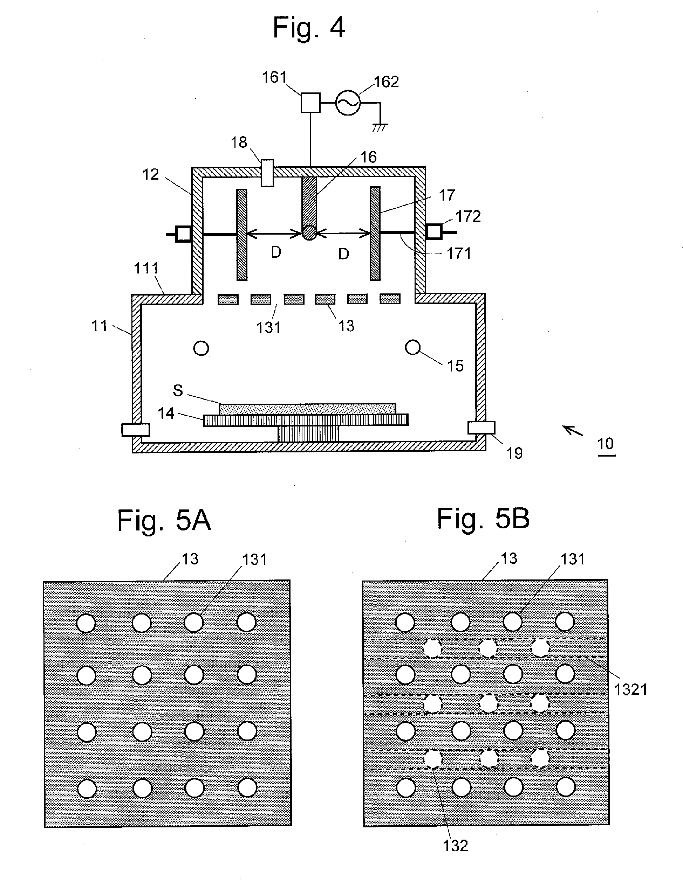

The first embodiment of the plasma processing device according to the present invention is schematically shown by a vertical sectional view in Fig. 4. The plasma processing device 10 of the present embodiment includes a plasma processing chamber 11 consisting of a rectangular parallelepiped vacuum container and a plasma producing chamber 12 which also consists of a rectangular parallelepiped vacuum container, the plasma producing chamber 12 being attached to the top panel (upper wall) 111 of the plasma processing chamber 11. A separation plate 13 having a large number of perforations 131 for generating a differential pressure between the plasma processing chamber 11 and the plasma producing chamber 12 is provided at the boundary between the plasma processing chamber 11 and the plasma producing chamber 12.

Inside the plasma processing chamber 11, a substrate table 14 on which a substrate S is to be placed is provided, facing the separation plate 13. The substrate table 14 has a built-in heater, whereby the substrate S can be heated, whenever necessary, during the film formation process. Processing-gas introduction ports 15 for introducing a processing gas into the plasma processing chamber 11 are provided at a level between the separation plate 13 and the substrate table 14 in the plasma processing chamber 11. Evacuation ports 19 for discharging gas from the plasma processing chamber are provided in the lower portion of the plasma processing chamber 11.

Inside the plasma producing chamber 12, a radio-frequency antenna 16 created by bending a conductor rod into a U-shape is provided. Both ends of the radio-frequency antenna 16 are fixed to the upper wall of the plasma producing chamber 12. Similar to the experiment system shown in Fig. 1, one end of this antenna is connected to a radio-frequency power source 162 via an impedance matching box 162, while the other end is grounded.

Two plasma control plates 17 are located on both sides of the radio-frequency antenna 16 and at equal distances from the same antenna 16. An operation rod 171 is connected to each of the plasma control plates 17. This operation rod 171 can be moved in its longitudinal direction by a moving mechanism 172 so as to change the position of the plasma control plate 17. Thus, by using the operation rod 171 and the moving mechanism 172 which serve as the moving system for the control plates 17, the distance between the plasma control plates 17 and the radio-frequency antenna 16 can be regulated. Additionally, a plasma-producing gas introduction port 18 for introducing a plasma-producing gas into the plasma producing chamber 12 is provided in the wall of the same chamber.

An operation of the plasma processing device 10 of the first embodiment is hereinafter described, using the example of forming a silicon thin film.
Initially, hydrogen (H₂) gas as the plasma-producing gas is introduced from the plasma-producing gas introduction port 18 into the plasma producing chamber 12. Meanwhile, a gas which contains SiH₄ gas as the processing gas is introduced from the processing-gas introduction ports 15 into the plasma processing chamber 11. The pressure in the plasma processing chamber 11 is regulated to be equal to or lower than 1 Pa, whereas the pressure in the plasma producing chamber 12 is regulated to be 2 Pa, which is higher than the pressure in the plasma processing chamber 11. Thus, a differential pressure is created between the plasma processing chamber 11 and the plasma producing chamber 12 to prevent the processing gas (SiH₄ gas) introduced into the plasma processing chamber 11 from entering the plasma producing chamber 12 through the perforations of the separation plate 13.

Subsequently, a 13.56-MHz, 1,000-watt radio-frequency electric power is supplied to the radio-frequency antenna 16, whereby a cloud of plasma containing atomic hydrogen radicals and electrons are produced in the plasma producing chamber 12. The plasma produced in the plasma producing chamber 12 is diffused through the perforations of the separation plate 13 into the plasma processing chamber 11. The electrons are also diffused from the plasma producing chamber 12 and decompose the SiH₄ gas introduced from the processing-gas introduction ports 15, creating silane-group radicals containing SiH₃. The hydrogen radicals produced in the plasma producing chamber 12 also pass through the perforations of the separation plate 13 and, together with the silane-group radicals produced in the plasma processing chamber, form a silicon thin film on the substrate S. During the process of forming the silicon thin film, the substrate S is maintained at a temperature of 200 °C by the heater.

The previously described operation is almost the same as that of conventional plasma processing devices. However, as a characteristic function of the plasma processing device 10 of the present embodiment, the distance between the plasma control plates 17 and the radio-frequency antenna 16 can be regulated so as to control the energy distribution of the electrons in the plasma within the plasma producing chamber 12. As demonstrated in the previously described experiment, bringing the plasma control plates 17 closer to the radio-frequency antenna 16 increases the ratio of the electrons in high-energy regions. This condition promotes the generation of atomic hydrogen radicals. It is also possible to fine-tune the electron temperature of the plasma so as to prevent an excessive dissociation of the radicals. By controlling and regulating the energy distribution and/or temperature of the electrons in the plasma in this manner, a high-quality thin film can be produced.

Another characteristic function of the plasma processing device 10 of the present embodiment, which is difficult to be realized by conventional plasma processing devices, is that the pressure in the plasma producing chamber 12 is made to be higher than the pressure in the plasma processing chamber 11 by the separation plate 13 between the plasma producing chamber 12 and the plasma processing chamber 11, so as to prevent an excessive dissociation of SiH₄ molecules which occurs if the SiH₄ gas which has been introduced into the plasma processing chamber 11 flows into the plasma producing chamber 12, where the high-energy electrons are present with a high ratio, and passes through an area near the antenna 16 in the plasma processing chamber 12. Furthermore, as in the present embodiment, if the plasma produced in the plasma producing chamber 12 is diffused through the separation plate 13 into the plasma processing chamber 11, the electrons in the diffused plasma have an energy distribution in which the proportion of high-energy electrons is lower than in the energy distribution of the electrons in the plasma produced in the plasma producing chamber 12. In the case of conventional plasma processing devices, when atomic hydrogen radicals need to be generated in high density, it is difficult to prevent an excessive dissociation of the SiH₄ gas since the SiH₄ molecules pass through the same plasma producing area. By contrast, in the plasma processing device 10 of the present embodiment, the plasma producing chamber 12 which serves as a reaction space for producing atomic hydrogen radicals by the dissociation of H₂ gas, can be spatially separated from the plasma processing chamber 11 which serves as a reaction space for dissociating the SiH₄ gas. Accordingly, unlike the conventional devices in which it is difficult to simultaneously achieve both the generation of atomic hydrogen radicals in high density and the suppression of excessive dissociation of the SiH₄ gas, the plasma processing device of the present embodiment is capable of achieving both the generation of atomic hydrogen radicals in high density and the suppression of excessive dissociation of the SiH₄ gas so as to form a high-quality silicon thin film on a substrate.

The separation plate 13 may have only the perforations 131 (Fig. 5A), or it may additionally have processing-gas introduction holes 132 (Fig. 5B). The processing-gas introduction holes 132 are provided only on the side of the separation plate 13 facing the plasma processing chamber 11. Through these holes, a processing gas introduced into the processing-gas introduction tubes 1321 embedded in the plate can be supplied into the plasma processing chamber 11. When this structure is adopted, the processing gas will be introduced at locations near the perforations 13, so that the diffused plasma introduced through the perforations 131 into the plasma processing chamber 11 can efficiently decompose the processing gas, while preventing an excessive dissociation of the processing gas.

Other than the previously described example of forming a silicon thin film, the plasma processing device 10 of the present embodiment can also be effectively used in the case of creating an oxide film or nitride film. In the case of an oxide film, oxygen gas is introduced into the plasma producing chamber 12 to create atomic oxygen radicals in high density, and simultaneously, a gas of an organic metal (for example, tri-methyl-aluminum, or TMAl, which is a raw material of aluminum) is introduced into the plasma processing chamber 11. By this method, a high-quality oxygen film can be formed on a substrate. In the case of a nitride film, ammonia gas (NH₃) is introduced into the plasma producing chamber 12 to create atomic nitrogen radicals in high density. These radicals are made to react with a gas of an organic metal introduced into the plasma processing chamber 11 to form a nitride film.

The distance between the plasma control plates 17 and the radio-frequency antenna 16 is appropriately set according to the conditions of the film formation. For example, it is possible to specify the distance based on the result of a preliminary experiment performed for various distances, and fix the distance at the specified value during the process of forming a thin film. It is also possible to change the distance as needed while measuring the energy of the electrons in the plasma producing chamber 12 and/or the plasma processing chamber 11 by using a Langmuir probe.

### SECOND EMBODIMENT

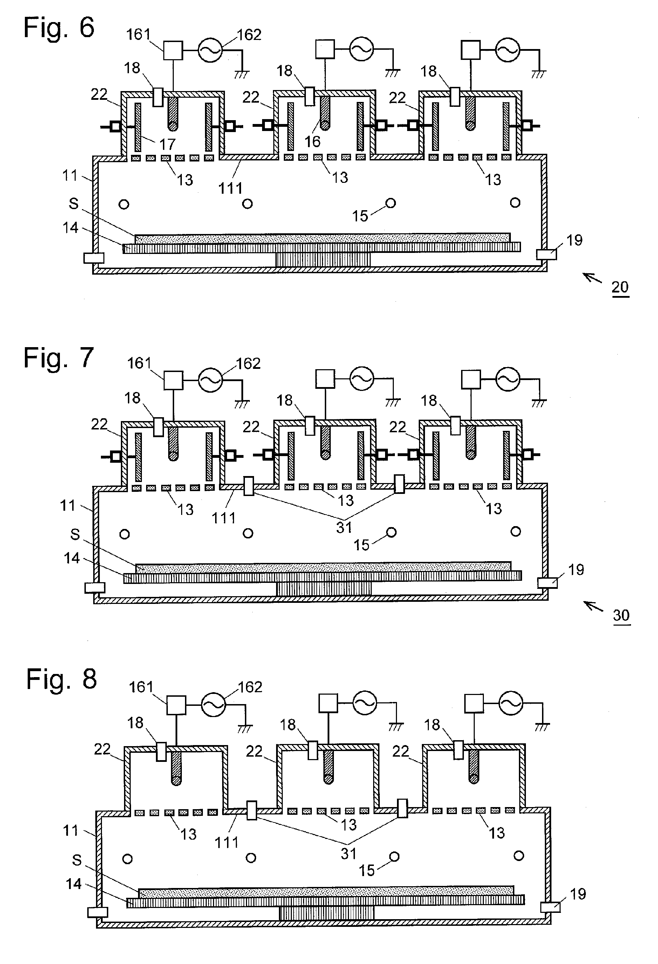

Fig. 6 is a vertical sectional schematic view of the second embodiment of the plasma processing device according to the present invention. The plasma processing device 20 of the present embodiment has the same structure as the plasma processing device 10 of the first embodiment except that a plurality of plasma producing chambers 22 are provided on the top panel 111 of one plasma processing chamber 11.

In the plasma processing 20 of the present embodiment, the energy of the electrons in the plasma in each of the plasma producing chambers 22 can be easily and individually controlled by independently adjusting the position of the plasma control plates 17 in each of the plasma producing chambers 22. By this system, the process can be controlled so that the deposition rate will be uniform over the entire substrate S. Accordingly, a highly uniform thin film can be produced even if the substrate has a large area. The state of plasma can be varied from one chamber to another; for example, different kinds of gas can be respectively introduced into the plasma producing chambers. In this manner, the film formation can be performed with a high degree of freedom.

### THIRD EMBODIMENT

Fig. 7 is a vertical sectional schematic view of the third embodiment of the plasma processing device according to the present invention. The plasma processing device 30 of the present embodiment is a variation of the plasma processing device 20 of the second embodiment, in which an upper evacuation port 31 for discharging gas from the plasma processing chamber 11 is provided in the top panel 111 between each neighboring pair of the plasma processing chambers 22. Though not shown, a vacuum pump (evacuation system) and an evacuation rate regulator for regulating the evacuation rate of the vacuum pump are provided at each of the upper evacuation ports 31.

Normally, the evacuation of the plasma processing chamber 11 is performed through the evacuation ports (lower evacuation ports) 19 provided at a level lower than the substrate S. This is to prevent the processing gas for the film deposition from being excessively discharged. By contrast, in the plasma processing device 30 of the present embodiment, another set of evacuation ports (specifically, the upper evacuation ports 31) are arranged at equal intervals in the plasma processing chamber 11, and the evacuation rate at each evacuation port is regulated by means of the evacuation rate regulator so that the processing gas introduced in the plasma processing chamber 11 will always be retained in the plasma processing chamber for almost the same length of time. This prevents an excessive dissociation of the processing gas in the plasma processing chamber due to the plasma produced in the plasma producing chamber, thereby enabling the formation of a high-quality, large-area semiconductor film, such a silicon thin film, oxide film or nitride film, on a substrate.

The technique of providing the upper evacuation ports 31 can be suitably used in a plasma processing device having no plasma control plate 17, as shown in Fig. 8.

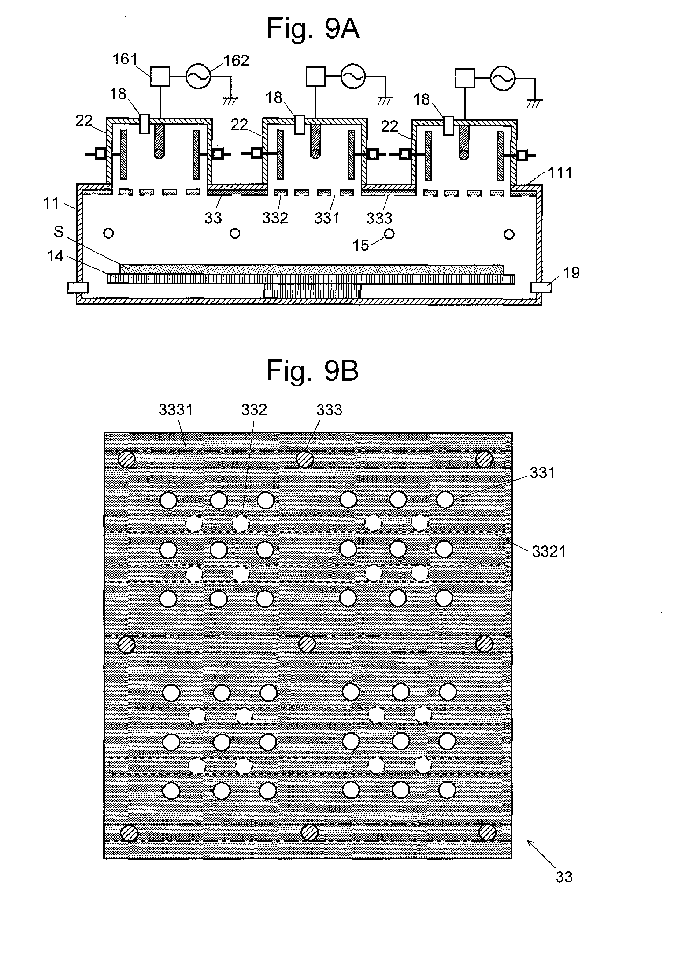

As another variation of the third embodiment, a plasma processing device having a structure as shown in Figs. 9A and 9B may be used. In this plasma processing device, a plurality of plasma producing chambers 22 are connected to the plasma processing chamber 11 via a separation plate 33. As shown in the vertical sectional view of Fig. 9A and the bottom view of Fig. 9B, in this separation plate 33, perforations 331 and processing-gas introduction holes 332 are provided directly under each plasma processing chamber 22, while evacuation holes 333 are provided in each area between the plasma producing chambers 22. These evacuation holes 333 correspond to the upper evacuation ports 31 of the third embodiment. The evacuation holes 333 lead to the evacuation tubes 331 embedded in the separation plate 33. Though not shown, a vacuum pump and an evacuation rate regulator are provided for the evacuation tubes 3331 to control the gas flow so that the processing gas introduced into the plasma processing chamber 11 will always be retained in the plasma processing chamber for almost the same length of time.

It should be noted that the plasma processing device according to the present invention is not limited to the first through third embodiments. For example, as opposed to those embodiments using a U-shaped radio-frequency antenna, a variety of radio-frequency antennas used in a conventional inductively coupled plasma processing device, such as a plate-shaped radio-frequency antenna or a spiral coil, can be used as the radio-frequency antenna. Furthermore, unlike the previously described embodiments in which one radio-frequency antenna is provided in each of the plasma producing chambers, a plurality of radio-frequency antennas may be provided in each of the plasma producing chambers. It is also possible to provide the antenna outside the plasma processing chamber.
Although the descriptions in the previously described embodiments were focused on the film deposition process, the present invention is not limited to the film deposition process. For example, the present invention can be applied to etching, ashing, cleaning, or other types of plasma processes that require the density control of the radicals.

### EXPLANATION OF NUMERALS

10, 20, 30... Plasma Processing Device
11... Plasma Processing Chamber
111... Top Panel
12, 22... Plasma Producing Chamber
13, 33... Separation Plate
131, 331 ... Perforation
132, 332... Processing-Gas Introduction Hole
1321, 3321... Processing-Gas Introduction Tube
133, 333... Evacuation Hole
1331,3331... Evacuation Tube
14... Substrate Table
15... Processing-Gas Introduction Port
16... Radio-Frequency Antenna
161, 521... Impedance Matching Box
162, 522... Radio-Frequency Power Source
17, 54... Plasma Control Plate
171... Operation Rod
172... Moving Mechanism
18... Plasma-Producing Gas Introduction Port
19... Evacuation Port (Lower Evacuation Port)
31... Upper Evacuation Port
51... Cross-Tube Chamber
52... Radio-Frequency Antenna

## Claims

1. A plasma processing device having: a plasma producing chamber; a radio-frequency antenna provided in the plasma producing chamber; a plasma-producing gas introduction unit for introducing a plasma-producing gas into the plasma producing chamber; a plasma processing chamber communicating with the plasma producing chamber; and a processing-gas introduction unit for introducing a processing gas into the plasma processing chamber, comprising:
a plasma control plate provided in the plasma producing chamber in such a manner that a distance thereof from the radio-frequency antenna is variable; and
a moving system for moving the plasma control plate.

2. The plasma processing device according to claim 1, wherein a plurality of the plasma producing chambers are provided.

3. The plasma processing device according to claim 1 or 2, comprising a differential pressure generator for generating a differential pressure between the plasma producing chamber and the plasma processing chamber.

4. The plasma processing device according to claim 3, wherein the differential pressure generator is a plate with a number of perforations, provided at a boundary between the plasma producing chamber and the plasma processing chamber.

5. The plasma processing device according to claim 4, wherein a processing-gas introduction hole doe introducing the processing gas is provided on a side of the plate facing the plasma processing chamber.

6. The plasma processing device according to claim 4 or 5, wherein:
the plate covers a plurality of the plasma processing chambers provided at regular intervals on a same wall surface of the plasma processing chamber; and
an evacuation system for discharging gas from the plasma processing chamber, and an evacuation rate regulator for regulating the evacuation rate of the evacuation system, are provided in each area of the plate between the plasma producing chambers.

7. The plasma processing device according to one of claims 2-5, wherein:
the plurality of the plasma processing chambers are provided at regular intervals on a wall surface of the plasma processing chamber; and
an evacuation system for discharging gas from the plasma processing chamber, and an evacuation rate regulator for regulating the evacuation rate of the evacuation system, are provided between the plasma producing chambers.

8. A plasma processing device having: a plasma producing chamber; a radio-frequency antenna provided in the plasma producing chamber; a plasma-producing gas introduction unit for introducing a plasma-producing gas into the plasma producing chamber; a plasma processing chamber communicating with the plasma producing chamber; and a processing-gas introduction unit for introducing a processing gas into the plasma processing chamber, wherein:
a plurality of the plasma processing chambers are provided at regular intervals on a wall surface of the plasma processing chamber; and
an evacuation system for discharging gas from the plasma processing chamber, and an evacuation rate regulator for regulating the evacuation rate of the evacuation system, are provided between the plasma producing chambers.

9. The plasma processing device according to claim 8, comprising a differential pressure generator for generating a differential pressure between the plasma producing chamber and the plasma processing chamber.

10. The plasma processing device according to claim 9, wherein the differential pressure generator is a plate with a number of perforations, provided at a boundary between the plasma producing chamber and the plasma processing chamber.

11. The plasma processing device according to claim 10, wherein a processing-gas introduction hole doe introducing the processing gas is provided on a side of the plate facing the plasma processing chamber.

12. The plasma processing device according to claim 10 or 11, wherein the plate covers a plurality of the plasma processing chambers provided at regular intervals on a same wall surface of the plasma processing chamber.
